# EUROPEAN PATENT APPLICATION

(11) **EP 2 685 463 A1**
(43) Date of publication of application: **15.01.2014**
(21) Application number: 11860782.9
(22) Date of filing: 15.11.2011
(51) Int. Cl.: H01B 5/14, H05K 3/00

(54) **PATTERNED FLEXIBLE TRANSPARENT CONDUCTIVE SHEET AND MANUFACTURING METHOD THEREOF**

(30) Priority: 11.03.2011 CN 201110058431
(71) Applicant: Nanchang O-Film Tech. Co., Ltd., Nanchang, Jiangxi 330013 (CN)
(72) Inventor: CUI, Zheng, Suzhou Jiangsu 215123 (CN); GAO, Yulong, Suzhou Jiangsu 215123 (CN); CHEN, Linsen, Suzhou Jiangsu 215123 (CN); ZHOU, Xiaohong, Suzhou Jiangsu 215123 (CN)
(74) Representative: Lewin, David Nicholas
(86) International application number: PCT/CN2011/001910
(87) International publication number: WO 2012/122690

(57) **Abstract**

A patterned flexible transparent conductive sheet and a manufacturing method thereof are provided. The transparent conductive sheet comprises a flexible transparent base, transparent imprint glue and a conductive film embedded in the transparent imprint glue. The surface of the imprint glue is provided with patterned and interconnected groove web. The total area outside of the groove web is more than 80 percent of the total surface of the transparent conductive sheet. The depth of the groove is less than the thickness of the transparent imprint glue. The conductive film is formed by sintered conductive ink. The conductive ink is uniformly filled at the bottom of the interconnected grooves. The thickness of the conductive film is less than the depth of the groove. The transparent conductive sheet is provided with the conductive web formed by the conductive film and a transmitting area outside of the groove web.

## Description

### FIELD OF THE INVENTION

The present invention relates to a manufacturing method for a transparent conductive sheet, and more particularly relates to a transparent conductive sheet based on imprinting and scratching conductive ink technology and a manufacturing method thereof.

### BACKGROUND OF THE INVENTION

The transparent conductive sheet is a sheet having a good electrical conductivity and a high transmittance in the visible light. Currently, the transparent conducting sheets have been widely used in the fields such as flat panel displays, photovoltaic devices, touch panels, and electromagnetic shielding, thus having a very broad market space. With the rapid development of the device toward the direction of light and thin, the flexible transparent conductive sheet has become the focus of the study, due to its thin, soft, etc. features.

The flexible transparent conductive sheet can generally be divided into two types, i.e. patterned type and non-patterned type. In most practical applications, such as touch screens, the former often requires exposure, imaging, etching and cleaning processes to pattern the transparent conductive film before use. While the latter will undoubtedly be the main development direction of the transparent conductive sheet, because of the higher production efficiency and the omission of patterning process which is complex and easily causes pollution to the environment.

ITO has dominated the market of the transparent conductive sheet. The method for manufacturing a patterned ITO film mainly includes screen printing, ink jet printing method, and lift-off processes in the semiconductor manufacturing process. However, due to the limited indium mineral resources and poor resistance to bending of ITO, the patterned transparent conductive sheet based on nano-metal materials has become the optimal solution under the above background.

The manufacturing method for the patterned transparent conductive sheet based on nano-metal materials is usually a printing method including following steps: conductive ink is firstly prepared by metal material with nano particle size, then an improved printing process is carried out to print the conductive ink on the flexible surface of the transparent substrate, finally, the conductive ink is sintered to form desired conductive networks. The width of a network wire of the network oversteps the resolution of the human eye, areas on the flexible surface without network wire are light-transmission regions. The surface square resistance and the light transmittance are controllable within a certain range by changing the width and the geometry of the wire. The patterned flexible transparent conductive sheets with excellent performance have been acquired using printing method by Japanese companies Dai Nippon Printing, Fujifilm and Gunze, as well as German company PolyIC. Among them, the sheet obtained by PolyIC has a graphics resolution of 15µm, a surface square resistance of 0.4-1Ω/sq, and a light transmittance exceeding 80%.

Nevertheless, the conductive network of the transparent conductive sheet manufactured by the printing method is a protrusion structure exposed on a surface of the transparent substrate, thus it has a poor scratch-resistance and anti-scratch capability. In addition, the graphics resolution of this structure is limited by the printing technique and can hardly been increased. In order to meet the application requirement of high-definition, the graphics resolution of the network must be further reduced. Finally, due to the limitation of the printing technique, the amount of conductive ink of the fixed line width is also difficult to increase, in other words, on the premise of determined line width and conductive ink, it is difficult to increase the amount of the conductive materials, and to improve the conductivity of the sheet.

### SUMMARY OF THE INVENTION

In order to overcome the deficiencies of the prior art, the present invention provides a patterned flexible transparent conductive sheet and a method for manufacturing the flexible transparent conductive sheet, such that a conductive network is embedded in trenches of a layer of transparent polymer, and anti-scratch resistance of the conductive sheet is enhanced, and the volume of the conductive sheet in the fixed line width is increased, thus further improving the conductivity of the conductive sheet.

In one object of the present invention, a technical solution is provided as:

A patterned flexible transparent conductive sheet, from bottom to top, includes: a flexible transparent substrate; a transparent imprint glue integrally bonded to the substrate; and a conductive material located on a surface of the transparent imprint glue; wherein the surface of the transparent imprint glue defmes a patterned and interconnected trench network, a total area outside the trench network is more then 80% of an area of the sheet, a depth of the trench is less than a thickness of the transparent imprint glue; the conductive material is a conductive ink before sintering and is a conductive film after sintering, the conductive film is evenly filled in a bottom of the trench network and interconnected, a thickness of the conductive film is less than the depth of the trench network; the sheet comprises a conductive network formed by the conductive film and a light transmitting region located outside the trench network.

Preferably, the patterned and interconnected trench network is a trench combination using a polygon trench as a basic unit, wherein a shape of the basic unit is selected from the group consisting of square, rectangular, round, regular hexagonal, regular triangle, and a combination thereof, and two adjacent basic unit are communicated via a shared side, or two adjacent basic unit are communicated via a single trench to form a discrete trench array.

Preferably, a radial cross-section of any trench of the trench network is rectangular having a greater trench depth than a trench width, and the trench width is ranged from 500nm to 10µm.

Preferably, the transparent imprint glue is a film structure selected from the group consisting of a thermoplastic polymer, a thermosetting polymer, and a UV-curable polymer, and the light transmittance in visible light thereof exceeds 90%.

Preferably, the conductive film is at least one selected from the group consisting of metal, carbon nanotubes, graphene ink, and conductive polymer material, which has a solid flexible film structure under normal state after sintering.

In addition, in another object of the present invention, a technical solution is provided as:

A method for manufacturing the patterned flexible transparent conductive sheet includes the following steps: I, designing and determining a three-dimensional structure of a conductive network according to demand, the conductive network being prepared according to a trench network on a transparent imprint glue of the sheet, wherein a total area outside the trench network is more than 80% of an area of the sheet, a depth of the trench is greater than a width of the trench; II, manufacturing a die having a microstructure complementary to the trench network using a micromachining process combining lithography techniques with micro-electroforming or diamond cutting; III, forming the trench network on the transparent imprint glue using the die through an imprint technology; and IV, filling a conductive ink in the trench network and sintering the conductive ink.

Preferably, in step I, the designing of the three-dimensional structure of the conductive network comprises: ① selecting raw materials for manufacturing the transparent conductive sheet, the raw materials comprising a flexible transparent substrate, a transparent imprint glue, and a conductive material; ② coating the transparent imprint glue with a fixed thickness on a surface of the substrate to form a transparent composite material, and determining a light transmittance *a* of the transparent composite material in visible light; ③ determining a geometric structure and line width *d* of the trench network on the premise of *a*×*b>t,* wherein t represents the light transmittance of the desire transparent conductive sheet, and *b* represents a ratio of light transmitting area outside the trench network to the total area of the sheet; and ④ determining a trench depth *h* according to a resistance and a solid content of the conductive ink combined with the obtained trench depth and a test result of a surface square resistance of the transparent conductive sheet.

Preferably, the method of filling the conductive ink in step IV comprises scratch or aerosol printing.

The present invention has the following features and advantages:

It is proposed that the conductive ink is filled in the trench and sintered to form the conductive network of the transparent conductive sheet. The basic idea is to fill a sufficient quantity of conductive ink in the trench of the transparent imprint glue, the conductive ink is then dried and sintered to form the transparent conductive sheet. Because the specific volume ratio of the electrically conductive material is generally small, the thickness of the conductive material sheet is consequently less than the depth of the trench. Therefore, the conductive network obtained by the method is embedded in the trench of the transparent imprint glue and is well-protected, and the scratch-resistance and anti-scratch capability is greatly improved.

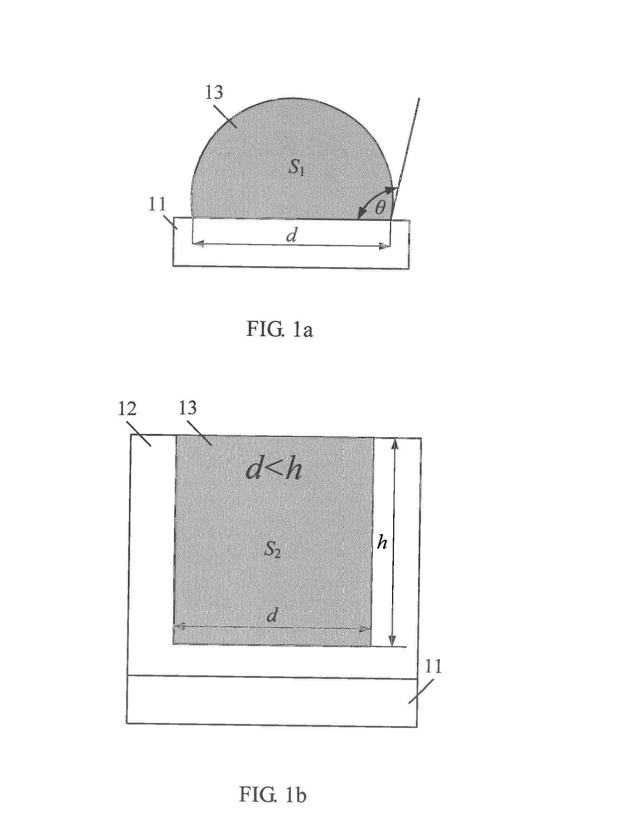

It is proposed to use the trench having a rectangular cross-section and a depth/width ratio being greater than 1:1 to constraint the flow of conductive ink. Before sintering, a cross-section of the conductive sheet obtained by printing technique is shaped as an essentially hemispherical, as shown in FIG. 1a and FIG. 1b. Under the same line width, its area is definitely less than that of a rectangular with "depth greater than the width". Therefore, this method can maximize the volume of the conductive sheet having a fixed line width, and thus the conductivity of the transparent conductive sheet is improved to the maximum extent. That is the second innovation different from the conventional transparent conductive sheet.

### BRIEF DESCRIPTION OF THE DRAWINGS

FIG. 1a is a schematic, cross-sectional view of a conductive ink before sintering;
FIG. 1b is a schematic, cross-sectional view of a conductive ink filled in a trench before sintering;
FIG. 2 is a schematic, planar view of a transparent conductive sheet sintered by an embodiment of the trench network of the present invention;
FIG. 3 is an isometric perspective view of a sintered transparent conductive sheet shown in FIG. 2;
FIG. 4 is a flowchart of a method for designing the trench network;
FIG. 5 is schematic, planar view of a transparent conductive sheet sintered by another embodiment of the trench network of the present invention;

### DETAILED DESCRIPTION

Reference will now be made to the drawings to describe, in detail, embodiments of the present invention.

Embodiment One, a transparent conductive sheet is manufactured by trench combination using a regular hexagonal trench as a basic unit.

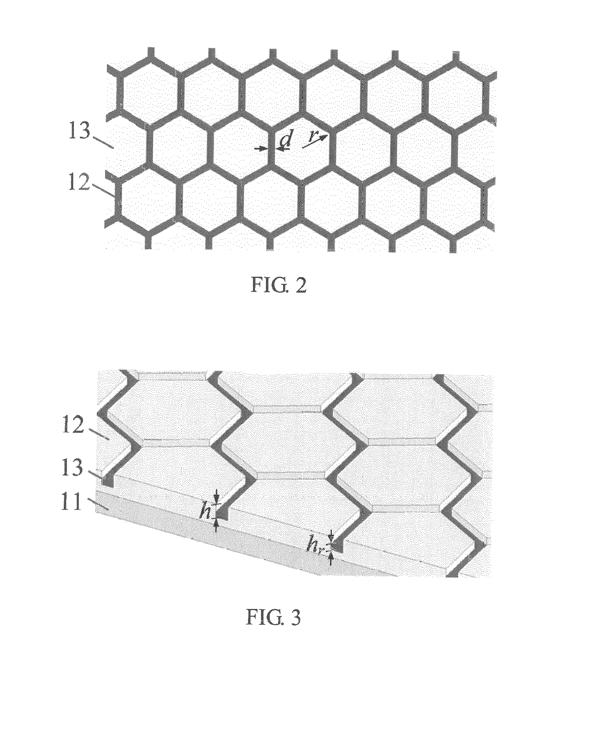

In the illustrated embodiment, referring to FIG. 2 and FIG. 3, a patterned transparent conductive sheet includes a flexible transparent substrate 11, a layer of transparent imprint glue 12 integrally bonded to the substrate 11, and a conductive film 13 evenly filled in a bottom of the trench of the transparent imprint glue 12.

The flexible transparent substrate 11 is a PET with a thickness of 100µm. The transparent imprint glue 12 is solvent-free UV curing acrylic resin with a thickness of 5µm. The trench network defined on a surface of the transparent imprint glue 12 forms a hexagonal array. The radius *r* of a hexagon circumscribed circle of the hexagonal array equates 5µm, the trench width *d* is ranged from 500nm to 10µm, preferably 1µm, depth *h* is 2µm, an angle of the sidewall is approximately 82°. The sintered conductive film 13 is silver, which is evenly filled in the bottom of the transparent imprint glue 12 and is interconnected. A thickness of the silver film is approximately 300nm. The trench network filled with the silver film forms a conductive network, and the area outside of the trench is non-conductive light transmitting region. A ratio c of the total area outside the trench to the total area of the transparent conductive sheet is 82.6%. The light transmittance of the transparent conductive sheet in visible light is 72%, and the surface square resistance is 2Ω/sq.

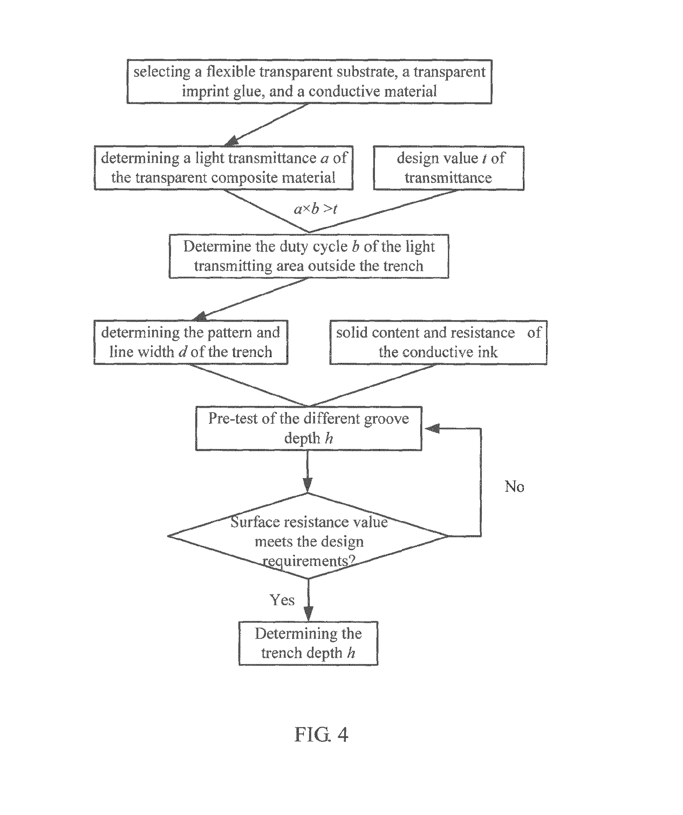

Referring to FIG. 4, a process to manufacture the patterned flexible transparent conductive sheet specifically includes the following steps:

I, a two-dimensional pattern of a conductive network, i.e. trench network is designed according to demand, and a desired trench depth is determined. As shown in FIG. 3, the designing process specifically includes:① a PET with a light transmittance greater than 90% is selected, in this embodiment, the PET has the light transmittance in visible light *a*=90% and a thickness of 100µm; the transparent imprint glue 12 is solvent-free UV curing acrylic resin with a viscosity of 100cps; the conductive ink is nano-silver conductive ink having a particle size ranged from 2 to 10 nm and with a solid content of about 41 %, a viscosity of 53cps, a surface tension of 30dyne/cm; ② the UV imprint glue 12 with a thickness of 5µm is coated on a surface of the PET 11, and a light transmittance of the transparent composite substrate in visible light is determined as *a≈* 90% ; ③ according to a design specifications of a transmittance of transparent conductive sheet *t*>72% (t represents an absolute transmittance) and *a*×*b>t, b*>80% is thus obtained; a hexagonal honeycomb trench network with good isotropic resistance is selected, and on the premise of *b,* the trench width *d*=1µm is determined in combination with the die processing capability; ④ the solid content of the silver ink is about 32%, the sintering temperature is 140°C, the sintering time is 5 minutes, and the measured resistivity is 2.5µΩ•cm. The surface square resistance of the transparent conductive sheet is required less than 10Ω/sq. Under the above conditions, when the test trench depth h equates 2µm, the resulting surface square resistance is 8 Ω/sq, which meets the design requirement.

II, using DMD-based laser direct writing platesetter, the trench network is defmed in a photoresist layer coated on a surface of a flat glass; a Ni film die is then manufactured having a microstructure complementary to the trench network using micro-electroforming technology; the die is coated onto a surface of a roller to form a roller die.

III, using roll-to-roll UV imprinting technique, the designed trench network is formed on the transparent imprint glue 12 of a surface of the PET 11. The curing wavelength of the transparent imprint glue 12 is 365nm, when cumulative irradiation energy reaches 360∼500mj/cm², the glue is cured.

IV, the conductive silver ink is filled in the trench network using scratch process. Specifically, the process includes the following steps: (1) the silver ink with a thickness of 5µm is coated on the surface of the transparent imprint glue 12; (2) the silver ink positioned outside the trench is scratched off by a steel scraper; (3) the silver ink is sintered using infrared-assisted hot-air oven, and conductive silver network is formed, wherein the sintering temperature is 140°C, the sintering time is 5 minutes.

Embodiment Two: transparent conductive sheet are manufactured by trench combination with a square trench as a basic unit.

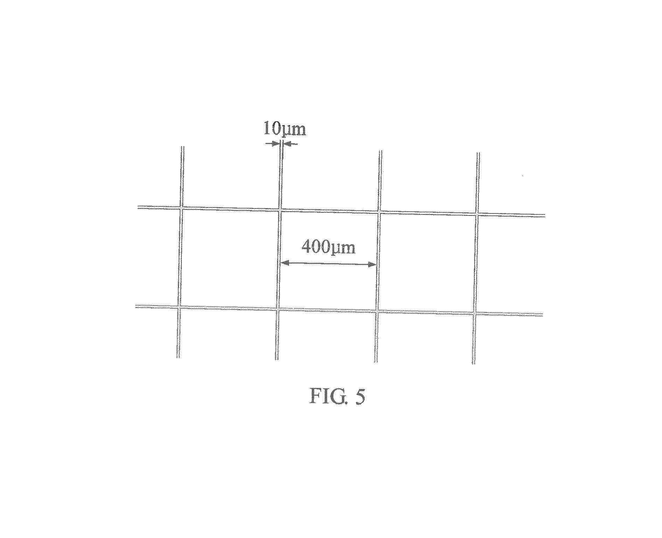

In this embodiment, referring to FIG. 5, a patterned transparent conductive sheet includes a flexible transparent substrate 11, a layer of transparent imprint glue 12 disposed on the substrate 11, and a conductive film 13 evenly filled in a bottom of the trench of the transparent imprint glue 12.

The flexible transparent substrate 11 is PC with a thickness of 50µm. The transparent imprint glue 12 is PMMA with a thickness of 6µm. The trench network defined in a surface of the transparent imprint glue 12 forms a square array. A side length of the square is 400µm, the trench width d is 10µm, depth *h* is 11µm, an angle of the sidewall is approximately 88°. The sintered conductive film 13 is copper, which is evenly filled in the bottom of the trench network of the transparent imprint glue and is interconnected. The thickness of the copper film is approximately 1µm. The trench network filled with the copper film forms a conductive network, and areas outside of the trench are non-conductive light transmitting regions. A ratio c of a total area outside the trench to the total area of the transparent conductive sheet is 95.5%. The light transmittance of the transparent conductive sheet in visible light is 89%, and the surface square resistance is 7Ω/sq.

Referring to FIG. 4, a process to manufacture the patterned flexible transparent conductive sheet specifically includes the following steps:

I, a two-dimensional pattern of a conductive network, i.e. trench network is designed according to demand, and a desired trench depth is determined. As shown in FIG. 3, the designing process specifically includes: ① a PC with a high light transmittance is selected which has the light transmittance in visible light *a*=91% and a thickness of 50µm; the transparent imprint glue 12 is PMMA with a viscosity of 4000cps; the conductive ink is nano-copper conductive ink having a particle size ranged from 2 to 10 nm and with a solid content of about 40%, a viscosity of 8-18cps, a surface tension of 17-21mN/m; ② the PMMA with a thickness of 15µm is coated on the surface of the PET 11, and a light transmittance of the transparent composite substrate in visible light is determined as *a*≈91%; ③ according to a design specifications of a transmittance of transparent conductive sheet *t*>85% (t represents absolute transmittance) and *a*×*b>t, b*>93% is thus obtained; a resistance square array trench network is selected, and on the premise of *b*, the trench width *d*=10µm is determined in combination with the aerosol printing capabilities; ④ the solid content of the copper ink is about 40%, the resistivity is 5-7µΩ•cm. The surface square resistance of the transparent conductive sheet is required less than 10Ω/sq. Under the above conditions, when the test trench depth h equates 11µm, the resulting surface square resistance is 7 Ω/sq, which meets the design requirements.

II, the designed trench network is engraved on a copper surface using a diamond cutting process, a Ni film die is then manufactured having a microstructure complementary to the trench network using micro-electroforming technology; the die is coated onto a surface of a roller to form a roller die.

III, using roll-to-roll UV imprinting technique, the designed trench network is formed on the PMMA 12 of a surface of the PET 11. The imprinting temperature of PMMA is 160°C.

IV, the copper ink is filled in the trench network using aerosol printing technology. The copper ink is sintered using pulse UV curing system to form the conductive copper network. The pulse energy is 207 J / pulse, frequency is 25 pulses/s, time is 1 second.

The above detailed description of two embodiments is aimed at facilitating the understanding of the technical solution of the present invention, but not to limit the scope of the embodiment of the present invention. In the described embodiments, the light transmittance of the transparent conductive sheet can be freely controlled by changing the ratio of trench width *d* to a radius *r* of the hexagon circumscribed circle; and the square resistance of the transparent conductive sheet can be freely controlled by changing trench depth *h* and the solid content of the silver ink. The conductive ink may include other metal ink, carbon nanotubes ink, graphene ink, or conductive polymer material ink, which has a solid flexible film structure under normal state after sintering.

In addition, the said patterned and interconnected trench network is a trench combination using a polygon trench as a basic unit, wherein a shape of the basic unit is selected from the group consisting of square (Embodiment Two), rectangular, round, regular hexagonal (Embodiment Three), regular triangle, and a combination thereof, and two adjacent basic unit are communicated via a shared side, or two adjacent basic unit are communicated via a single trench to form a discrete trench array (not shown).

## Claims

1. A patterned flexible transparent conductive sheet, from bottom to top, the sheet comprising:
a flexible transparent substrate;
a transparent imprint glue integrally bonded to the substrate; and
a conductive material located on a surface of the transparent imprint glue;
wherein the surface of the transparent imprint glue defines a patterned and interconnected trench network, a total area outside the trench network is more then 80% of an area of the sheet, a depth of the trench is less than a thickness of the transparent imprint glue; the conductive material is a conductive ink before sintering and is a conductive film after sintering, the conductive film is evenly filled in a bottom of the trench network and
interconnected, a thickness of the conductive film is less than the depth of the trench network; the sheet comprises a conductive network formed by the conductive film and a light transmitting region located outside the trench network.

2. The patterned flexible transparent conductive sheet according to claim 1, wherein the patterned and interconnected trench network is a trench combination using a polygon trench as a basic unit, wherein a shape of the basic unit is selected from the group consisting of square, rectangular, round, regular hexagonal, regular triangle, and a combination thereof, and two adjacent basic unit are communicated via a shared side, or two adjacent basic unit are communicated via a single trench to form a discrete trench array.

3. The patterned flexible transparent conductive sheet according to claim 1, wherein a radial cross-section of any trench of the trench network is a rectangular having a greater trench depth than a trench width, and the trench width is ranged from 500nm to 10µm.

4. The patterned flexible transparent conductive sheet according to claim 1, wherein the transparent imprint glue is a film structure selected from the group consisting of a thermoplastic polymer, a thermosetting polymer, and a UV-curable polymer, and the light transmittance in visible light thereof exceeds 90%.

5. The patterned flexible transparent conductive sheet according to claim 1, wherein the conductive film is at least one selected from the group consisting of metal, carbon nanotubes, graphene ink, and conductive polymer material, which has a solid flexible film structure under normal state after sintering.

6. A method for manufacturing the patterned flexible transparent conductive sheet according to claim 1, comprising the following steps:
I, designing and determining a three-dimensional structure of a conductive network according to demand, the conductive network being prepared according to a trench network on a transparent imprint glue of the sheet, wherein a total area outside the trench network is more than 80% of an area of the sheet, a depth of the trench is greater than a width of the trench;
II, manufacturing a die having a microstructure complementary to the trench network using a micromachining process combining lithography techniques with micro-electroforming or diamond cutting;
III, forming the trench network on the transparent imprint glue using imprint technology;
and
IV, filling a conductive ink in the trench network and sintering the conductive ink.

7. The method according to claim 6, wherein in step I, the designing of the three-dimensional structure of the conductive network comprises:
① selecting raw materials for manufacturing the transparent conductive sheet, the raw materials comprising a flexible transparent substrate, a transparent imprint glue, and a conductive material;
② coating the transparent imprint glue with a fixed thickness on a surface of the substrate to form a transparent composite material, and determining a light transmittance *a* of the transparent composite material in visible light;
③ determining a geometric structure and line width *d* of the trench network on the premise of *a*×*b>t,* wherein *t* represents the light transmittance of the desire transparent conductive sheet, and *b* represents a ratio of light transmitting area outside the trench network to the total area of the sheet; and
④ determining a trench depth *h* according to a resistance and a solid content of the conductive ink combined with the obtained trench depth and a test result of a surface square resistance of the transparent conductive sheet.

8. The method according to claim 6, wherein the method of filling the conductive ink in step IV comprises scratch or aerosol printing.
